(19) Europäisches Patentamt
European Patent Office
Office européen des brevets

(11) EP 2 768 240 A1

(12) **EUROPEAN PATENT APPLICATION**

(43) Date of publication:
20.08.2014 Bulletin 2014/34

(51) Int Cl.:
H04R 1/08 (2006.01)        H04R 1/38 (2006.01)
H04R 1/04 (2006.01)        H04R 19/00 (2006.01)

(21) Application number: 14154540.0

(22) Date of filing: 10.02.2014

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 15.02.2013 JP 2013027451

(71) Applicant: Funai Electric Co., Ltd.
Daito-shi,
Osaka 574-0013 (JP)

(72) Inventor: Inoda, Takeshi
Daito-shi, Osaka 574-0013 (JP)

(74) Representative: Global IP Europe
Patentanwaltskanzlei
Pfarrstraße 14
80538 München (DE)

(54) **Sound input device**

(57) A sound input device includes a housing, a microphone housing, a vibrator, and first and second sound guide components. The housing has first and second sound collection holes. The microphone housing has first and second microphone sound holes. The first and second sound guide components communicate with the first and second sound collection holes and the first and second microphone sound holes, respectively. The microphone housing has a first microphone inner space that communicates with the first microphone sound hole and one side of the diaphragm of the vibrator, and a second microphone inner space that communicates with the second microphone sound hole and the other side of the diaphragm. A spacing between the first sound collection hole and the second sound collection hole is wider than a spacing between the first microphone sound hole and the second microphone sound hole.

FIG. 2

**Description**

CROSS-REFERENCE TO RELATED APPLICATIONS

This application claims priority to Japanese Patent Application No. 2013-027451 filed on February 15, 2013. The entire disclosure of Japanese Patent Application No. 2013-027451 is hereby incorporated herein by reference.

BACKGROUND

Field of the Invention

This invention generally relates to a sound input device.

Background Information

Generally, sound input devices with which sound input is possible and which execute signal processing related to inputted sound are well-known in the art. For example, sound input devices have been applied to portable telephones, headsets, and other such speech communication devices, information processing systems that make use of technology for analyzing inputted sound (such as voice authentication systems, voice recognition systems, command generation systems, electronic dictionaries, translators, and voice-input remote controls), audio recording devices, and so forth.

The sound input devices include a microphone unit. Various structures have been proposed for this microphone unit (see Japanese Unexamined Patent Application Publication No. H7-307990 (Patent Literature 1), for example). Patent Literature 1 discloses a microphone having four conduits that transmit acoustic energy from a port to a diaphragm. With this microphone, the four conduits all have the same length and cross sectional area.

SUMMARY

Generally, a differential microphone with excellent performance in terms of suppressing background noise is expected. This differential microphone generally includes a first sound guide space in which external sound is guided to one side of a diaphragm, and a second sound guide space in which sound is guided to the other side of the diaphragm. This differential microphone vibrates the diaphragm by means of a difference in sound pressure exerted on the two sides of the diaphragm, and converts input sound into an electrical signal based on this vibration.

It has been discovered that in applying a differential microphone such as this to a sound input device, both the sensitivity of the microphone and noise suppression performance need to be ensured. For instance, it has been discovered that if a differential microphone is configured so as to take into account the need for reducing size and thickness, it is difficult to make a plurality of sound guide spaces (e.g., first and second sound guide spaces) the same as in Patent Literature 1. As a result, it is difficult to ensure good noise suppression performance, for example.

One aspect is to provide a sound input device with which a proper sensitivity of a microphone and a proper noise suppression can be achieved.

In view of the state of the known technology, a sound input device is provided that includes a housing, a microphone housing, a vibrator, a first sound guide component, and a second sound guide component. The housing has first and second sound collection holes. The microphone housing is disposed inside the housing. The microphone housing has first and second microphone sound holes. The vibrator is disposed inside the microphone housing. The vibrator has a diaphragm. The first sound guide component communicates with the first sound collection hole and the first microphone sound hole. The second sound guide component communicates with the second sound collection hole and the second microphone sound hole. The microphone housing has a first microphone inner space that communicates with the first microphone sound hole and one side of the diaphragm inside the microphone housing, and a second microphone inner space that communicates with the second microphone sound hole and the other side of the diaphragm inside the microphone housing. A spacing between the first sound collection hole and the second sound collection hole is wider than a spacing between the first microphone sound hole and the second microphone sound hole.

Also other objects, features, aspects and advantages of the present disclosure will become apparent to those skilled in the art from the following detailed description, which, taken in conjunction with the annexed drawings, discloses one embodiment of the sound input device.

BRIEF DESCRIPTION OF THE DRAWINGS

Referring now to the attached drawings which form a part of this original disclosure:

FIG. 1 is a perspective view of the external configuration of a headset in accordance with one embodiment;
FIG. 2 is a cross sectional view of a microphone unit of the headset, taken along II-II line in FIGS. 1 and 3;
FIG. 3 is a front perspective view of the external configuration of the microphone unit of the headset illustrated in FIG. 1;
FIG. 4 is an exploded perspective view of the microphone unit illustrated in FIG. 3;
FIG. 5 is a top plan view of a substrate component of the microphone unit of the headset;
FIG. 6 is a bottom plan view of a cover component of the microphone unit of the headset;

FIG. 7 is a graph illustrating the relation between sound pressure and the distance from a sound source;

FIG. 8 is a diagram illustrating of the directional characteristics of the microphone unit of the headset;

FIG. 9 is a schematic diagram of the Helmholtz resonator;

FIG. 10 is a schematic diagram of the resonance tube;

FIG. 11 is a graph illustrating the relation between path length and resonance frequency in first and second spaces of the headset;

FIG. 12 is a graph illustrating the frequency characteristics of a space in a microphone installation structure;

FIG. 13 is a cross sectional view of the configuration of a microphone unit of a headset in accordance with a modification example; and

FIG. 14 is a cross sectional view of the configuration of a microphone unit of a headset in accordance with another modification example.

DETAILED DESCRIPTION OF EMBODIMENTS

A selected embodiment will now be explained with reference to the drawings. It will be apparent to those skilled in the art from this disclosure that the following descriptions of the embodiment are provided for illustration only and not for the purpose of limiting the invention as defined by the appended claims and their equivalents.

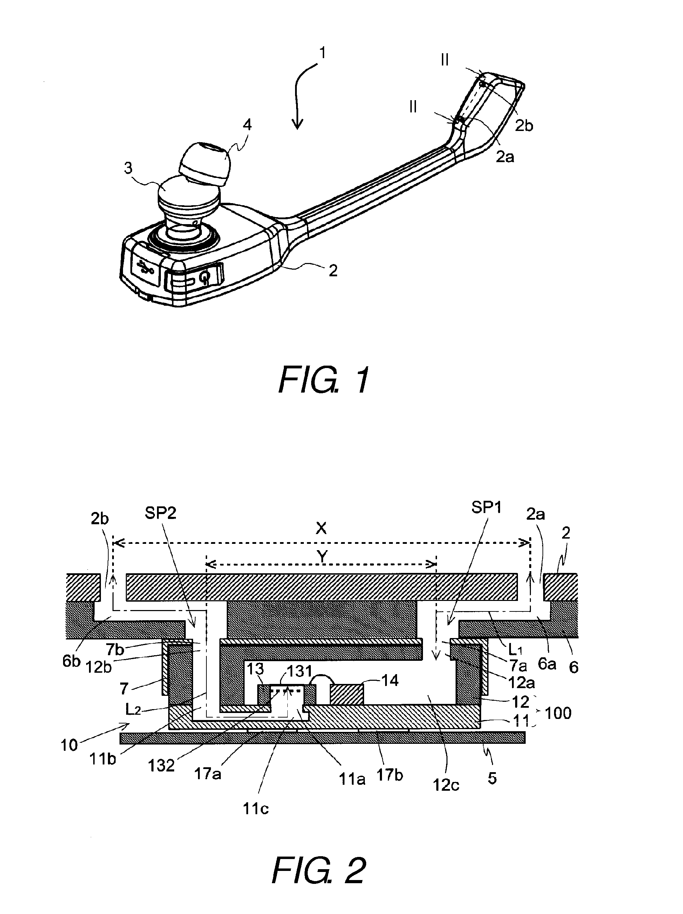

Referring initially to FIGS. 1 to 12, a headset 1 (e.g., a sound input device) is illustrated in accordance with one embodiment. In the illustrated embodiment, the head set 1 is an example of the sound input device of the present invention. In the illustrated embodiment, while the headset 1 is illustrated as an example of the sound input device, it will be apparent to those skilled in the art from this disclosure that the present invention can be applied to different types of sound input device, such as portable telephones and other such voice communication devices, information processing systems that make use of technology for analyzing inputted voice (such as voice authentication systems, voice recognition systems, command generation systems, electronic dictionaries, translators, and voice input remote controls), recording devices, and so forth.

Referring now to FIG. 1, a basic configuration of the headset 1 will be described. FIG. 1 is a simplified oblique view of the external configuration of the headset 1. The headset 1 basically has a housing 2, a speaker component 3, an earpiece 4, and a microphone unit 10 (see FIG 2). The housing 2 of the headset 1 has a slender shape. The speaker component 3 is disposed at one end of this housing 2, and the microphone unit 10 is disposed at the other end (although not shown in FIG. 1). The housing 2 has a first sound collection hole 2a and a second sound collection hole 2b, as shown in FIG. 1. The first and second collection holes 2a and 2b allow sound to be inputted to the microphone unit 10. The first and second collection holes 2a and 2b are formed on the same face at the end of the housing 2 where the microphone unit 10 is disposed. The headset 1 is used in a state in which the earpiece 4 provided to the distal end of the speaker component 3 has been inserted into the user's ear hole, and the two sound collection holes 2a and 2b are disposed near the user's mouth. The headset 1 can be mounted to a part of the user's body (such as the ear or head) with a mounting mechanism (not shown).

In this embodiment, the first sound collection hole 2a and the second sound collection hole 2b both have the same size and shape. The shape of the sound collection holes 2a and 2b is substantially stadium-shaped (substantially rectangular) in plan view in this embodiment, but is not limited to this, and can instead be circular in plan view, for example.

FIG. 2 is a simplified cross section of the microphone unit 10, taken along II-II line in FIG. 1. As shown in FIG. 2, the microphone unit 10 is mounted on a mounting board 5 inside the housing 2, and the microphone unit 10 is attached in a state in which a sealing material 6 (gasket) is disposed between the microphone unit 10 and the housing 2. In this embodiment, a shield cover 7 is attached to the microphone unit 10 to improve resistance to external electromagnetic fields. However, this shield cover 7 can be omitted in some cases.

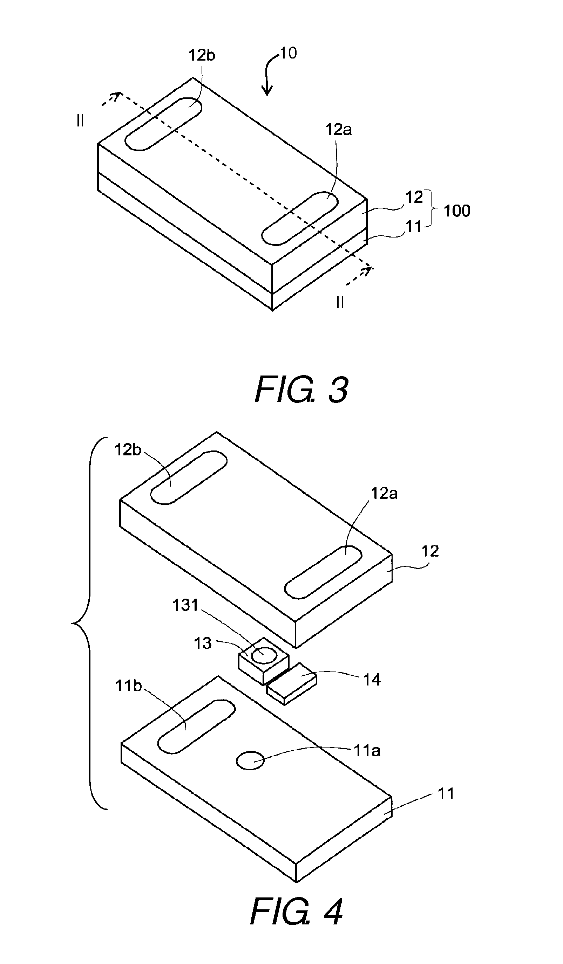

The detailed configuration of the microphone unit 10 of the headset 1 will now be described in detail. FIG. 3 is a simplified oblique view of the external configuration of the microphone unit 10 of the headset 1. FIG. 4 is a simplified and exploded oblique view of the configuration of the microphone unit 10 shown in FIG. 3. As shown in FIGS. 3 and 4, the microphone unit 10 basically has a substantially cuboid external shape. The microphone unit 10 includes a substrate component 11 and a cover component 12 that is disposed on the substrate component 11 and is coupled to the cover component 12. The substrate component 11 and the cover component 12 form a microphone housing 100 (an example of the microphone housing of the present invention).

The substrate component 11 has first and second openings 11a and 11b. The first opening 11a is substantially circular in plan view, and is formed near the center of the substrate component 11 provided in a substantially rectangular shape in plan view (see FIGS. 2 and 4). The second opening 11b is substantially stadium-shaped (substantially rectangular) in plan view, and is formed at one end in the lengthwise direction of the substrate component 11 (the left end in FIGS. 2 and 4). As shown in FIG. 2, the substrate component 11 also has a substrate internal space 11c. The substrate internal space 11 communicates with the first opening 11a and the second opening 11b, and is formed in the interior of the substrate component 11.

There are no particular restrictions on the substrate component 11 thus configured, but it can be formed by superposing a plurality of (such as three) substrates.

As shown in FIGS. 2 and 4, the microphone unit 10 further has a MEMS (Micro Electro Mechanical System) chip 13 and an ASIC (Application Specific Integrated Circuit) 14. The MEMS chip 13 is disposed on the upper face of the substrate component 11 so as to cover the first opening 11a. The ASIC 14 is disposed on the upper face of the substrate component 11 so as to be adjacent to the MEMS chip 13.

As shown in FIGS. 2 and 4, the MEMS chip 13 (an example of the vibrator of the present invention) includes a diaphragm 131 and a fixed electrode 132 that is disposed opposite the diaphragm 131 at a specific spacing. Specifically, the MEMS chip 13 forms a capacitor-type microphone chip. The ASIC 14 amplifies the electrical signals that are obtained based on the change in electrostatic capacity of the MEMS chip 13 (which is attributable to vibration of the diaphragm 131). The ASIC 14 can be formed integrally with the MEMS chip 13. The vibrator of the present invention can, however, be formed by something other than a capacitor-type microphone chip.

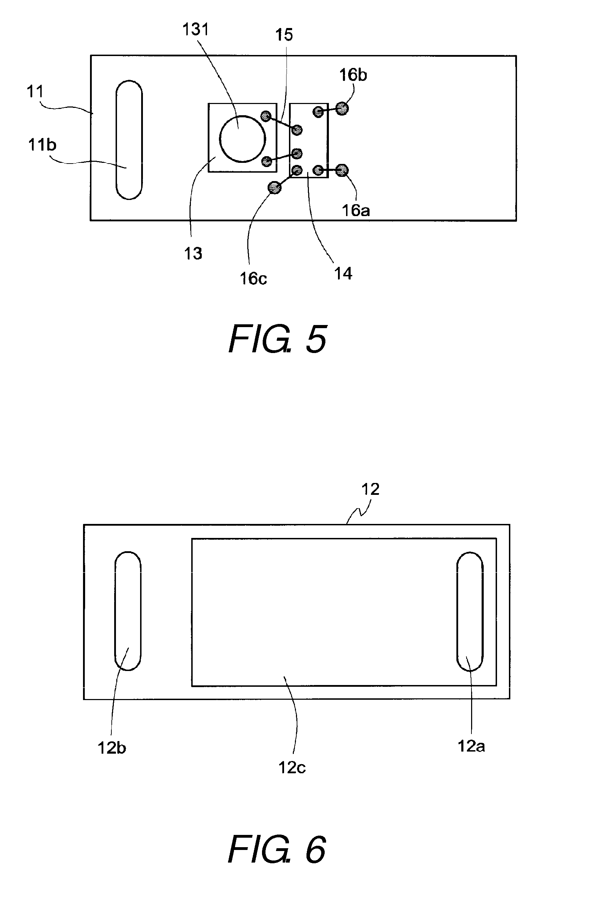

FIG. 5 is a simplified plan view of the substrate component of the microphone unit 10 of the headset 1, as seen from above and in a state in which the MEMS chip 13 and the ASIC 14 have been installed. The electrical connection relation between the MEMS chip 13 and the ASIC 14, and so forth will be described through reference to FIG. 5.

The MEMS chip 13 and the ASIC 14 are joined onto the substrate component 11 using a die bonding material (such as an adhesive agent based on an epoxy resin or a silicone resin). The MEMS chip 13 is joined onto the substrate component 11 so that there is no gap between its bottom face and the upper face of the substrate component 11, in order to prevent acoustic leakage. The MEMS chip 13 is electrically connected to the ASIC 14 by wires 15 (preferably gold wires).

The ASIC 14 is electrically connected to a plurality of electrode terminals 16a, 16b, and 16c formed on the upper face of the substrate component 11 by the wires 15. The electrode terminal 16a is a power supply terminal used for inputting power supply voltage (VDD). The electrode terminal 16b is an output terminal for outputting electrical signals amplified by the ASIC 14. The electrode terminal 16c is a ground terminal used for making a ground connection.

The power supply terminal 16a is electrically connected via wiring (not shown; including through-wiring) to a power supply pad 17a (see FIG. 2) that is provided to the lower face of the substrate component 11 and is used for external connections. The output terminal 16b is electrically connected via wiring (not shown; including through-wiring) to an output pad 17b (see FIG. 2) that is provided to the lower face of the substrate component 11 and is used for external connections. The ground terminal 16c is electrically connected via wiring (not shown; including through-wiring) to a ground pad (not shown) that is provided to the lower face of the substrate component 11 and is used for external connections.

FIG. 6 is a simplified plan view of the cover component 12 of the microphone unit 10 of the headset 1, as seen from below. The cover component 12 has a substantially cuboid external shape. The cover component 12 is provided such that its size in the lengthwise direction (the left and right direction in FIG. 6) and in the short-side direction (the up and down direction in FIG. 6) is substantially the same as the size of the substrate component 11 in the lengthwise direction (the up and down direction in FIG. 5) and in the short-side direction (the left and right direction in FIG. 5).

As shown in FIG. 6 (see FIG. 2, etc.), the cover component 12 has through-holes 12a and 12b. The through-hole 12a is substantially stadium-shaped (substantially rectangular) in plan view, and is provided at one end in the lengthwise direction of the cover component 12 (the right side in FIG. 6). The through-hole 12b has size and shape in plan view that are substantially the same as those of the through-hole 12a, and is provided at the other end in the lengthwise direction of the cover component 12 (the left side in FIG. 6). The two through-holes 12a and 12b are formed in the same face of the cover component 12 (the microphone housing 100). In plan view, the two through-holes 12a and 12b are disposed substantially symmetrically around the center of the cover component 12. The spacing between them (distance between centers) is about 5 mm, for example. The through-hole 12a corresponds to the first microphone sound hole of the present invention, and will be thus referred to hereinafter. The through-hole 12b corresponds to the second microphone sound hole of the present invention, and will be thus referred to hereinafter.

As shown in FIG. 6, the cover component 12 further has a concave component 12c that is substantially rectangular in plan view is formed in the cover component 12. This concave component 12c is provided so that part of it overlaps the first microphone sound hole 12a provided to the cover component 12. The concave component 12c is not linked to the second microphone sound hole 12b.

The microphone unit 10 is obtained by disposing the cover component 12 over the substrate component 11 on which the MEMS chip 13 and the ASIC 14 have been installed. Here, the MEMS chip 13 and the ASIC 14 are disposed within the concave component 12c. The cover component 12 is disposed so that the second microphone sound hole 12b overlaps the second opening 11b (provided over the substrate component 11).

The cover component 12 is joined onto the substrate component 11 by using an adhesive agent, an adhesive sheet, or the like so that there will be no acoustic leakage. With the microphone unit 10 in this embodiment, the sound wave path length from the first microphone sound hole 12a to the upper face of the diaphragm 131 is designed to be substantially the same as the sound wave path length from the second microphone sound hole 12b to the lower face of the diaphragm 131. However, this is just an example, and the above-mentioned two path lengths need not be the same.

Referring now to the microphone unit 10 in FIG. 2, sound waves inputted from the first microphone sound hole 12a propagate within the concave component 12c of the cover component 12 (corresponds to the first microphone inner space of the present invention), and reach the upper face of the diaphragm 131 of the MEMS chip 13. Sound waves inputted from the second microphone sound hole 12b propagate through a space formed by the second opening 11b, the substrate internal space 11c, and a first opening 131b (corresponds to the second microphone inner space of the present invention), and reach the lower face of the diaphragm 131 of the MEMS chip 13. A plurality of through-holes are formed in the fixed electrode 132 of the MEMS chip 13, which allow sound waves to pass through the fixed electrode 132.

The diaphragm 131 is vibrated by the pressure differential between the sound waves inputted from the first microphone sound hole 12a to the upper face of the diaphragm 131, and the sound waves inputted from the second microphone sound hole 12b to the lower face of the diaphragm 131. The generation of this vibration brings about a change in the electrostatic capacity of the MEMS chip 13. The ASIC 14 subjects the electrical signal that is obtained based on the change in electrostatic capacity of the MEMS chip 13 to amplification processing, and outputs the signal to the output terminal 16b (see FIG. 5). The electrical signal outputted to the output terminal 16b is then outputted through the external connection-use output pad 17b to the mounting board 5.

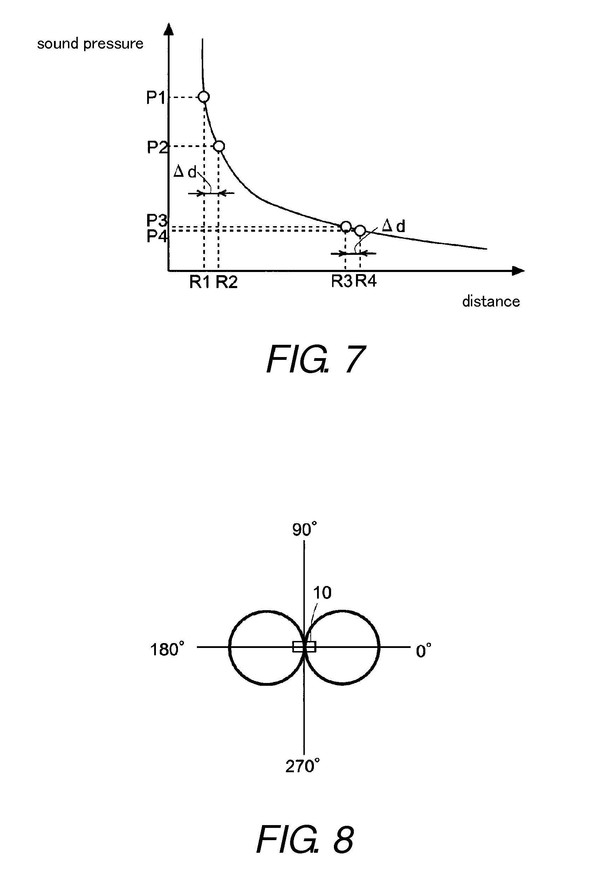

The characteristics of the microphone unit 10 will now be described. FIG. 7 is a graph of the relation between sound pressure and the distance from a sound source. As shown in FIG. 7, the sound pressure of the sound waves (the strength and amplitude of the sound waves) decays as the waves move through air or another such medium. Specifically, the sound pressure is inversely proportional to the distance from the sound source. The relation between the sound pressure P and the distance R is expressed by the following equation (1). k in the equation (1) is a proportional constant.

$$P = k/R \quad (1)$$

As is clear from FIG. 7 and the equation (1), the sound pressure quickly decays at a position near the sound source, but decays more gradually farther away from the sound source. Because of this, even though the distance between two positions is the same ($\Delta$d), it can be seen that the sound pressure decays considerably between two positions (R1 and R2) that are closer to the sound source, and the sound pressure does not decay very much between two positions (R3 and R4) that are farther away from the sound source.

FIG. 8 is a simplified diagram of the directional characteristics of the microphone unit 10 of the headset 1. In FIG. 8, the orientation of the microphone unit 10 is assumed to be the same as the orientation shown in FIG. 2. If the distance from the sound source to the diaphragm 131 is constant, then the sound pressure exerted on the diaphragm 131 will be at its maximum when the sound source is at 0° or 180°. This is because the difference between the distance from the first microphone sound hole 12a until the sound waves reach the upper face of the diaphragm 131 and the distance from the second microphone sound hole 12b until the sound waves reach to the lower face of the diaphragm 131 is also at its maximum.

In contrast, the sound pressure exerted on the diaphragm 131 will be lowest (0) when the sound source is at 90° or 270°. This is because the difference between the distance from the first microphone sound hole 12a until the sound waves reach the upper face of the diaphragm 131 and the distance from the second microphone sound hole 12b until the sound waves reach the lower face of the diaphragm 131 is substantially zero. Specifically, the microphone unit 10 is bidirectional, with high sensitivity to sound waves incident from a direction of 0° or 180°, and low sensitivity to sound waves incident from a direction of 90° or 270°.

The sound pressure of the target sound generated near the microphone unit 10 decays considerably between the first microphone sound hole 12a and the second microphone sound hole 12b. Accordingly, for the sound pressure of the target sound generated near the microphone unit 10, there will be a large difference between the sound pressure at the upper face of the diaphragm 131 and the sound pressure at the lower face. On the other hand, background noise is encountered at a position farther away from the sound source than the target sound. Thus, there is little decay between the first microphone sound hole 12a and the second microphone sound hole 12b. Accordingly, for background noise, there will be a small difference between the sound pressure at the upper face of the diaphragm 131 and the sound pressure at the lower face. It is assumed here that the distance from the sound source to the first microphone sound hole 12a is not the same as the distance from the sound source to the second microphone sound hole 12b.

Because there is less sound pressure difference in background noise received by the diaphragm 131, the sound pressure of background noise is substantially cancelled out at the diaphragm 131. By contrast, the sound pressure of the above-mentioned target sound is not cancelled out at the diaphragm 131 because there is the above-mentioned large difference in sound pressure of the target sound received at the diaphragm 131. Therefore, the microphone unit 10 has excellent performance in reducing the amount of background noise that is picked up, for target sound generated nearby.

Next, the installation structure of the microphone unit 10 when the microphone unit 10 configured as above is installed in the headset 1 (e.g., the sound input device) will be described in detail.

As discussed above, the microphone unit 10 is mounted to the mounting board 5 and disposed in the housing 2 in a state of being covered by the shield cover 7 (see FIG. 2). The sealing material 6, which prevents sound leakage and so forth, is sandwiched between the housing 2 and the microphone unit 10 covered by the shield cover 7.

The shield cover 7 has first and second through-holes 7a and 7b. The first through-hole 7a communicates with the first microphone sound hole 12a, and is formed in the shield cover 7. The second through-hole 7b communicates with the second microphone sound hole 12b, and is also formed in the shield cover 7. The sealing material 6 has first and second sound guide paths 6a and 6b. The first sound guide path 6a communicates between the first sound collection hole 2a provided to the housing 2 and the first through-hole 7a provided to the shield cover 7 covering the microphone housing 100, and is formed in the sealing material 6. Also, the second sound guide path 6b communicates between the second sound collection hole 2b provided to the housing 2 and the second through-hole 7b provided to the shield cover 7 covering the microphone housing 100, and is formed in the sealing material 6.

The first sound guide path 6a and the first through-hole 7a correspond to the first sound guide component of the present invention. The second sound guide path 6b and the second through-hole 7b correspond to the second sound guide component of the present invention.

The first sound guide path 6a does not extend straight over the first through-hole 7a, and instead bends away from the microphone unit 10 (to the right in FIG. 2). The second sound guide path 6b is similar in that it does not extend straight over the second through-hole 7b, and instead bends away from the microphone unit 10 (to the left in FIG. 2). Since this structure is employed, the distance X between the first sound collection hole 2a and the second sound collection hole 2b (distance between centers) is longer (greater) than the distance Y between the first microphone sound hole 12a and the second microphone sound hole 12b (distance between centers).

Employing this configuration makes it possible to reduce the size of the microphone unit 10 disposed in the headset 1, while improving the microphone sensitivity (microphone output) in the microphone unit 10. This is because increasing the spacing X between the first sound collection hole 2a and the second sound collection hole 2b affords a greater sound pressure difference between the sound pressure reaching the upper face of the diaphragm 131 and the sound pressure reaching the lower face of the diaphragm 131, for sound generated near the microphone unit 10.

With the microphone installation structure in this embodiment, the configuration allows microphone sensitivity to be increased as mentioned above, while preventing degradation in the noise suppression performance of the microphone unit 10. This will now be described.

With the microphone installation structure in this embodiment, a first space SP1 and a second space SP2 are formed as spaces in which external sound waves propagate to the diaphragm 131. The first space SP1 here is formed by using the first sound collection hole 2a, a first sound guide component (formed by the first sound guide path 6a and the first through-hole 7a), the first microphone sound hole 12a, and a first microphone inner space (formed by the concave component 12c). The second space SP2 is formed by using the second sound collection hole 2b, a second sound guide component (formed by the second sound guide path 6b and the second through-hole 7b), the second microphone sound hole 12b, and a second microphone inner space (formed by the second opening 11b, the substrate internal space 11c, and the first opening 11a).

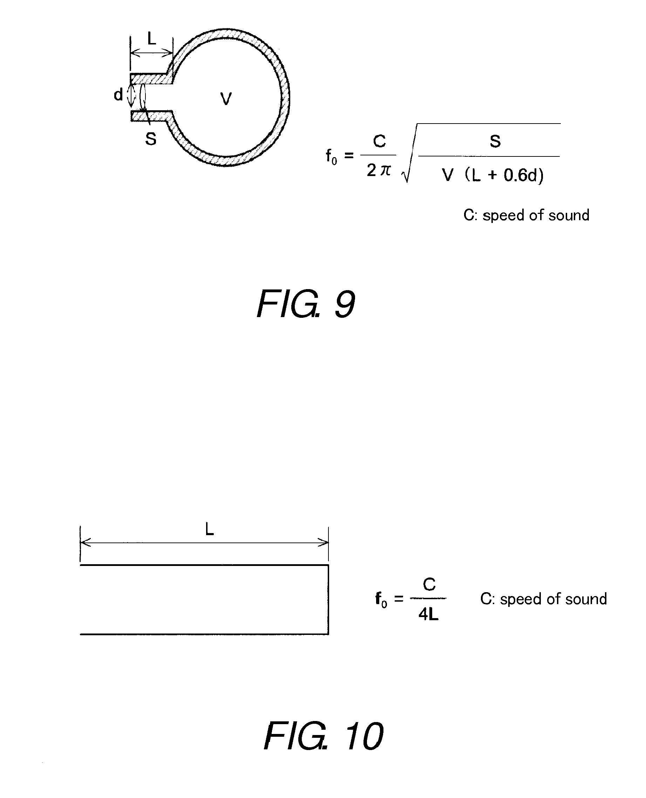

The first space SP1 is relatively narrow from the first sound collection hole 2a to the first microphone sound hole 12a, and its volume increases at the concave component 12c. Therefore, the first space SP1 can be considered to behave the same as a known Helmholtz resonator (shown in FIG. 9). When the first space SP1 is modeled as a Helmholtz resonator, the resonance frequency $f_0$ of the first space SP1 is given by the following equation (2).

$$f_0 = C/(2\pi) \cdot \sqrt{(S/(V(L_1 + 0.6d)))} \quad (2)$$

C: speed of sound
S: cross sectional area of the first sound collection hole 2a
V: volume of the concave component 12c (e.g., the first microphone inner space)
$L_1$: path length from the first sound collection hole 2a to the concave component 12c (see FIG. 2)
d: diameter of the first sound collection hole 2a

If the first sound collection hole 2a is not circular as in this embodiment, d can be a converted diameter obtained from the cross sectional area S, for example.

Meanwhile, the second space SP2 has a shape that looks like a tube that is slender from the second sound collection hole 2b to the lower face of the diaphragm 131. Therefore, the second space SP2 can be considered to behave the same as a well-known resonance tube (shown in FIG. 10). When the second space SP2 is modeled as a resonance tube, the resonance frequency $f_0$ of the second space SP2 is given by the following equation (3).

$$f_0 = C/(4L_2) \quad (3)$$

C: speed of sound

$L_2$: path length from the second sound collection hole 2b to the lower face of the diaphragm 131 (see FIG. 2)

In the equations (2) and (3), the path lengths ($L_1$ and $L_2$) can be the total distance obtained by linking a straight line passing through the centers of the spaces, for example.

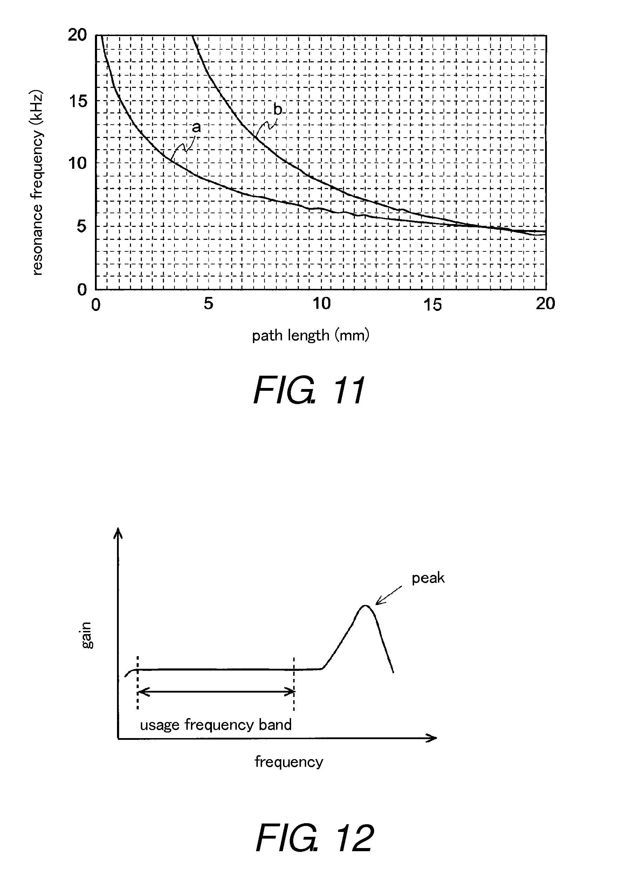

FIG. 11 is a graph of the relation between path length and resonance frequency in the first space SP1 and the second space SP2 of the headset 1. In FIG. 11, a is a graph of the first space SP1, and b is a graph of the second space SP2. In FIG. 11, the path length corresponds to the above-mentioned $L_1$ in the case of the first space SP1, and corresponds to the above-mentioned $L_2$ in the case of the second space SP2. As can be seen from FIG. 11, since the first space SP1 and the second space SP2 have different shapes (the resonance frequencies are found by different models), how the resonance frequency changes with respect to the path length is different.

As shown in the simplified diagram in FIG. 12, the resonance frequency of the two spaces SP1 and SP2 is preferably designed to be higher than the usage frequency band as much as possible. This affords better noise suppression performance in the microphone unit 10. The peak in FIG. 12 is attributable to the resonance frequency.

However, if the spacing between the first sound collection hole 2a and the second sound collection hole 2b is increased in an effort to obtain better microphone sensitivity, then the resonance frequency of the two spaces SP1 and SP2 will be lower and closer to the usage frequency band (see FIG. 11 as well). This means that the performance of the microphone unit 10 in the usage frequency band (noise suppression performance, frequency characteristics, etc.) can in some cases be adversely affected. If this happens, then the difference between the resonance frequency of the first space SP1 and the resonance frequency of the second space SP2 is preferably as small as possible, and preferably no more than about 3 kHz, for example. If this difference is kept as small as possible, then when acoustic resistance members of a given material are used, there will be less effect on the peak (see FIG. 12) in the two spaces SP1 and SP2, and there will be less degradation in the noise suppression performance, etc., of the microphone unit 10.

In the above case, it is more preferable if the resonance frequency of the first space SP1 and the resonance frequency of the second space SP2 are the same. However, to the extend that performance degradation can be suppressed using acoustic resistance members of a given material, then there can be a difference in the resonance frequencies of the two spaces SP1 and SP2.

Examples of acoustic resistance members include felt, mesh members, and so forth formed from a resin (such as polyester or nylon), stainless steel, or the like. The acoustic resistance members can be disposed so as to cover the sound collection holes 2a and 2b, or disposed so as to block off the sound guides in the spaces SP1 and SP2.

If the two spaces SP1 and SP2 have the same resonance frequency, then the installation structure of the microphone unit 10 can be designed so as to satisfy the following equation (4). The equation (4) is derived from the equations (2) and (3), and its $f_0$ is the same as in the equations (2) and (3).

$$L_1 = 4S/(\pi^2 V) \cdot L_2^2 - 0.6\sqrt{(4S/\pi)} \quad (4)$$

Next, a working example 1 will be described. In this working example 1, X (the spacing between the first sound collection hole 2a and the second sound collection hole 2b) is Δ 10 mm, S (the cross sectional area of the first sound collection hole 2a) is 1.45 mm², and V (the volume of the concave component 12c (the first microphone inner space)) is 10 mm³. In this case, if $L_1$ = 4.3 mm and $L_2$ = 9.2 mm, then the resonance frequency can be 9.2 kHz for both of the two spaces SP1 and SP2. With this configuration, good microphone sensitivity and good noise suppression performance can be obtained when the upper limit of the usage frequency band is 7 kHz. There are no particular restrictions on the lower limit to the usage frequency band, but an example is about 300 Hz.

Furthermore, a working example 2 will be described. In this working example 2, X (the spacing between the first sound collection hole 2a and the second sound collection hole 2b) is Δ 20 mm, S (the cross sectional area of the first sound collection hole 2a) is 1.45 mm², and V (the volume of the concave component 12c (the first microphone inner space)) is 10 mm³. In this case, if $L_1$ = 10 mm and $L_2$ = 13.5 mm, then the resonance frequency can be 6.3 kHz for both of the two spaces SP1 and SP2. With this configuration, good microphone sensitivity and good noise suppression performance can be obtained when the upper limit of the usage frequency band is 3.4 kHz.

In this example, however, part of the peak will fall within the usage frequency band if the upper limit of the usage frequency band is 7 kHz, for example. Here again, since the resonance frequencies match for the two spaces SP1 and SP2, the effect on the peak can be suppressed by disposing acoustic resistance members in the two spaces SP1 and SP2, for example. Specifically, acoustic resistance members can be used to easily provide the headset 1 having good microphone sensitivity and good noise suppression performance.

The embodiment given above is an example of the present invention, but the applicable scope of the present invention is not limited to or by the configuration in the above embodiment. Naturally, as long as the technological scope of the present invention is not exceeded, the above embodiment can be suitably modified.

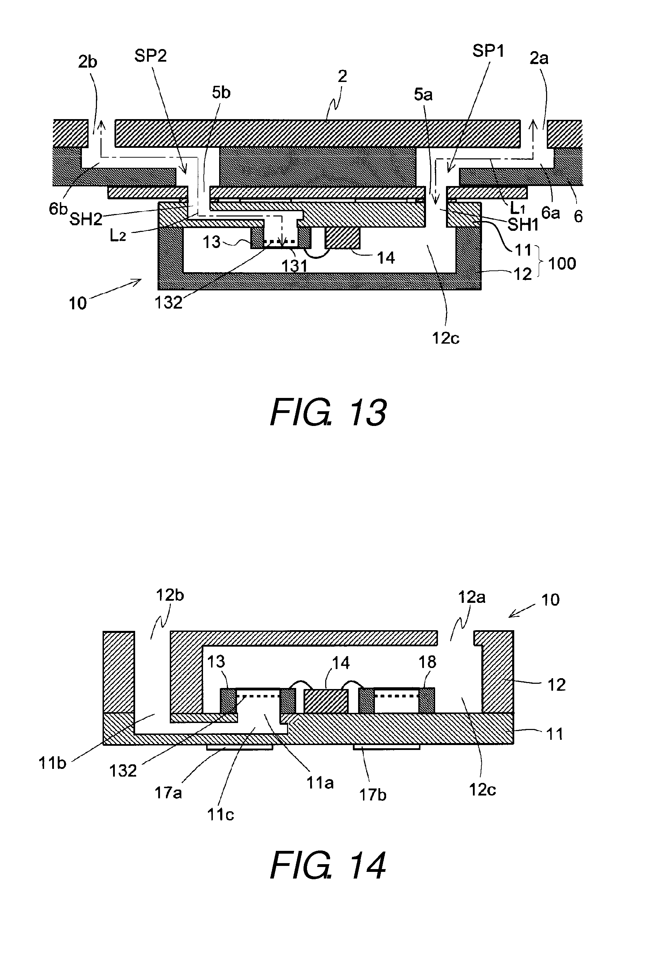

For instance, the configuration of the microphone unit 10 given above is just one example, and various modifications are possible. For example, the two microphone sound holes 12a and 12b of the microphone unit 10 are provided to the cover component 12. However, as shown in FIG. 13, for instance, two microphone sound holes can be provided to the substrate component 11, rather than to the cover component 12. Through-holes SH1 and SH2 in the substrate component 11 correspond to microphone sound holes.

In this case, as shown in FIG. 13, two through-holes 5a and 5b are provided to the mounting board 5. In the example shown in FIG. 13, the first sound guide path 6a and the through-hole 5a are used to form the first sound guide component of the present invention, and the second sound guide path 6b and the through-hole 5b are used to form the second sound guide component of the present invention. Again with the configuration shown in FIG. 13, the one space SP1 can be modeled with a Helmholtz resonator, and the other space SP2 can be modeled with a resonance tube. A shield cover is placed over the cover component 12 with the configuration shown in FIG. 13 as well.

Also, as shown in FIG. 14, an MEMS chip 18 can be disposed in addition to the MEMS chip 13 in the concave component 12c (provided to the cover component 12) of the microphone unit 10. This MEMS chip 18 can be provided in order to function as a non-directional microphone. With this configuration, the function of the headset 1 is expanded. Also, this configuration includes a bidirectional differential microphone and a non-directional microphone in a single package, and therefore has the advantage of achieving both a more compact size and multifunctionality.

The present invention is applied to a headset above, but the present invention is not limited to a headset, and can instead be applied to a portable telephone or another such speech communication device, an information processing system (such as a voice recognition system or a translator), or a sound recording device or another such sound input device.

In the illustrated embodiment, a sound input device is provided that includes a housing, a microphone housing, a vibrator, a first sound guide component, and a second sound guide component. The housing has first and second sound collection holes. The microphone housing is disposed inside the housing. The microphone housing has first and second microphone sound holes. The vibrator is disposed inside the microphone housing. The vibrator has a diaphragm. The first sound guide component communicates with the first sound collection hole and the first microphone sound hole. The second sound guide component communicates with the second sound collection hole and the second microphone sound hole. The microphone housing has a first microphone inner space that communicates with the first microphone sound hole and one side of the diaphragm inside the microphone housing, and a second microphone inner space that communicates with the second microphone sound hole and the other side of the diaphragm inside the microphone housing. A spacing between the first sound collection hole and the second sound collection hole is wider than a spacing between the first microphone sound hole and the second microphone sound hole.

With this configuration, a differential microphone is included that converts input sound into an electrical signal by vibrating the diaphragm by means of the difference in sound pressure exerted on both sides of the diaphragm inside the housing of the sound input device. Accordingly, the sound input device with excellent noise suppression performance is obtained with this configuration. Also, the spacing of the two sound collection holes provided to the housing is formed wider than the spacing of the two microphone sound holes provided to the microphone housing disposed inside this housing. Thus, the microphone provided inside the housing can be more compact, and microphone sensitivity can be enhanced.

With the sound input device, the housing has the first and second sound collection holes on a single face or the same face of of the housing. The microphone housing has the first and second microphone sound holes on a single face or the same face of the microphone housing. With this configuration, the path over which the sound collection holes provided to the housing communicate with the microphone sound holes provided to the microphone housing disposed inside the housing is kept from becoming complicated.

With the sound input device, the first sound collection hole, the first sound guide component, the first microphone sound hole, and the first microphone inner space define a first space that forms a Helmholtz resonator. The second sound collection hole, the second sound guide component, the second microphone sound hole, and the second microphone inner space define a second space that forms a resonance tube. With this configuration, it is easy for the microphone housing disposed inside the housing to be made thinner and more compact.

With the sound input device, the first and second spaces have resonance frequencies, respectively. The difference magnitude (the absolute value of the difference) of the resonance frequencies of the first and second spaces is set to 3 kHz or less. It is easy to obtain good noise suppression performance with this configuration. Furthermore, the magnitude of the difference between the resonance frequency of the first space (modeled with a Helmholtz resonator) and the resonance frequency of the second space (modeled with a resonance tube) can be designed as small as possible, particularly when these resonance frequencies are within the usage frequency band.

With the sound input device, the first and second spaces have resonance frequencies, respectively. The resonance frequencies of the first and second spaces are set to be substantially equal to each other. It is easy to obtain good noise suppression performance with this configuration. Also, with this configuration, it is possible to suppress the effect of peaks (some or all of them) originating in the resonance frequencies of the first and second spaces by using acoustic resistance members made of the same material, even when the peaks are within the usage frequency band. Specifically, with this configuration, ensuring good sensitivity of the microphone and ensuring good noise suppression performance can both be easily achieved.

With the sound input device, the housing, the microphone housing, the vibrator, the first sound guide component, and the second sound guide component are arranged with respect to each other such that the following relation is satisfied:

$$L_1 = 4S/(\pi^2 V) \cdot L_2^2 - 0.6 \sqrt{(4S/\pi)}$$

where $L_1$ is a path length from the first sound collection hole to the first microphone inner space, $L_2$ is a path length from the second sound collection hole to the other side of the diaphragm, S is a cross sectional area of the first sound collection hole, and V is a volume of the first microphone inner space.

With this configuration, the resonance frequency of the first space modeled with a Helmholtz resonator and the resonance frequency of the second space modeled with a resonance tube are designed so as to coincide. Accordingly, just as with the configuration above, ensuring good sensitivity of the microphone and ensuring good noise suppression performance can both be easily achieved.

With the sound input device, the first and second microphone inner spaces are isolated with respect to each other by the diaphragm of the vibrator inside the microphone housing.

With the sound input device, the microphone housing includes a substrate component and a cover component. T substrate component and the cover component define inside of the microphone housing. The vibrator is disposed on the substrate component inside the microphone housing.

With the sound input device, the substrate component of the microphone housing has the first and second microphone sound holes.

With the sound input device, the cover component of the microphone housing has the first and second microphone sound holes.

With the present invention, there is provided a sound input device with which the sensitivity of the microphone is good, while the noise suppression performance is excellent.

In understanding the scope of the present invention, the term "comprising" and its derivatives, as used herein, are intended to be open ended terms that specify the presence of the stated features, elements, components, groups, integers, and/or steps, but do not exclude the presence of other unstated features, elements, components, groups, integers and/or steps. The foregoing also applies to words having similar meanings such as the terms, "including", "having" and their derivatives. Also, the terms "part," "section," "portion," "member" or "element" when used in the singular can have the dual meaning of a single part or a plurality of parts unless otherwise stated.

Also it will be understood that although the terms "first" and "second" may be used herein to describe various components these components should not be limited by these terms. These terms are only used to distinguish one component from another. Thus, for example, a first component discussed above could be termed a second component and vice-a-versa without departing from the teachings of the present invention. The term "attached" or "attaching", as used herein, encompasses configurations in which an element is directly secured to another element by affixing the element directly to the other element; configurations in which the element is indirectly secured to the other element by affixing the element to the intermediate member(s) which in turn are affixed to the other element; and configurations in which one element is integral with another element, i.e. one element is essentially part of the other element. This definition also applies to words of similar meaning, for example, "joined", "connected", "coupled", "mounted", "bonded", "fixed" and their derivatives. Finally, terms of degree such as "substantially", "about" and "approximately" as used herein mean an amount of deviation of the modified term such that the end result is not significantly changed.

While only a selected embodiment has been chosen to illustrate the present invention, it will be apparent to those skilled in the art from this disclosure that various changes and modifications can be made herein without departing from the scope of the invention as defined in the appended claims. For example, unless specifically stated otherwise, the size, shape, location or orientation of the various components can be changed as needed and/or desired so long as the changes do not substantially affect their intended function. Unless specifically stated otherwise, components that are shown directly connected or contacting each other can have intermediate structures disposed between them so long as the changes do not substantially affect their intended function. The functions of one element can be performed by two, and vice versa unless specifically stated otherwise. It is not necessary for all advantages to be present in a particular embodiment at the same time. Every feature which is unique from the prior art, alone or in combination with other features, also should be considered a separate description of further inventions by the applicant, including the structural and/or functional concepts embodied by such feature(s). Thus, the foregoing descriptions of the embodiment according to the present invention are provided for illustration only, and not for the purpose of limiting the invention as defined by the appended claims and their equivalents.

## Claims

1. A sound input device comprising:

   a housing having first and second sound collection holes;
   a microphone housing disposed inside the housing, the microphone housing having first and second microphone sound holes;
   a vibrator disposed inside the microphone housing, the vibrator having a diaphragm;
   a first sound guide component communicating with the first sound collection hole and the first microphone sound hole; and
   a second sound guide component communicating with the second sound collection hole and the second microphone sound hole;
   the microphone housing having a first microphone inner space that communicates with the first microphone sound hole and one side of the diaphragm inside the microphone housing, and a second microphone inner space that communicates with the second microphone sound hole and the other side of the diaphragm inside the microphone housing,
   a spacing between the first sound collection hole and the second sound collection hole being wider than a spacing between the first microphone sound hole and the second microphone sound hole.

2. The sound input device according to claim 1, wherein
   the housing has the first and second sound collection holes on a single face of the housing, and
   the microphone housing has the first and second microphone sound holes on a single face of the microphone housing.

3. The sound input device according to claim 1 to 2, wherein
   the first sound collection hole, the first sound guide component, the first microphone sound hole, and the first microphone inner space defines a first space that forms a Helmholtz resonator, and
   the second sound collection hole, the second sound guide component, the second microphone sound hole, and the second microphone inner space defines a second space that forms a resonance tube.

4. The sound input device according to claim 1, 2 or 3, wherein

   the first and second spaces have resonance frequencies, respectively, with a difference magnitude of the resonance frequencies of the first and second spaces being set to 3 kHz or less.

5. The sound input device according to any one of claims 1 to 3, wherein
   the first and second spaces have resonance frequencies, respectively, with the resonance frequencies of the first and second spaces being substantially equal to each other.

6. The sound input device according to any one of claims 1 to 5, wherein
   the housing, the microphone housing, the vibrator, the first sound guide component, and the second sound guide component are arranged with respect to each other such that the following relation is satisfied:

   $$L_1 = 4S/(\pi^2 V) \cdot L_2{}^2 - 0.6 \sqrt{(4S/\pi)}$$

   where $L_1$ is a path length from the first sound collection hole to the first microphone inner space, $L_2$ is a path length from the second sound collection hole to the other side of the diaphragm, S is a cross sectional area of the first sound collection hole, and V is a volume of the first microphone inner space.

7. The sound input device according to any one of claims 1 to 6, wherein
   the first and second microphone inner spaces are isolated with respect to each other by the diaphragm of the vibrator inside the microphone housing.

8. The sound input device according to any one of claims 1 to 7, wherein
   the microphone housing includes a substrate component and a cover component, the substrate component and the cover component defining inside of the microphone housing,
   the vibrator being disposed on the substrate component inside the microphone housing.

9. The sound input device according to any one of claims 1 to 8, wherein
   the substrate component of the microphone housing has the first and second microphone sound holes.

10. The sound input device according to any one of claims 1 to 8, wherein
    the cover component of the microphone housing has the first and second microphone sound holes.

FIG. 1

FIG. 2

## FIG. 3

## FIG. 4

FIG. 5

FIG. 6

FIG. 7

FIG. 8

$$f_0 = \frac{C}{2\pi} \sqrt{\frac{S}{V\,(L + 0.6d)}}$$

C: speed of sound

## FIG. 9

$$f_0 = \frac{C}{4L} \qquad \text{C: speed of sound}$$

## FIG. 10

*FIG. 11*

*FIG. 12*

*FIG. 13*

*FIG. 14*

**EUROPEAN SEARCH REPORT**

Application Number

EP 14 15 4540

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/189300 A1 (INODA TAKESHI [JP] ET AL) 29 July 2010 (2010-07-29) * paragraphs [0001], [0002], [0030] - [0037], [0047] - [0049]; figure 7 * | 1-10 | INV. H04R1/08 H04R1/38 ADD. H04R1/04 H04R19/00 |
| A | US 2012/020510 A1 (TANAKA FUMINORI [JP] ET AL) 26 January 2012 (2012-01-26) * the whole document * | 1-10 | |
| A | US 2011/195745 A1 (INODA TAKESHI [JP] ET AL) 11 August 2011 (2011-08-11) * the whole document * | 1-10 | |

TECHNICAL FIELDS
SEARCHED        (IPC)

H04R

The present search report has been drawn up for all claims

| Place of search | Date of completion of the search | Examiner |
|---|---|---|
| Munich | 15 July 2014 | Kunze, Holger |

EPO FORM 1503 03.82 (P04C01)

### ANNEX TO THE EUROPEAN SEARCH REPORT
### ON EUROPEAN PATENT APPLICATION NO.

EP 14 15 4540

This annex lists the patent family members relating to the patent documents cited in the above-mentioned European search report.
The members are as contained in the European Patent Office EDP file on
The European Patent Office is in no way liable for these particulars which are merely given for the purpose of information.

15-07-2014

| Patent document cited in search report | Publication date | Patent family member(s) | Publication date |
|---|---|---|---|
| US 2010189300 A1 | 29-07-2010 | EP 2214418 A2 | 04-08-2010 |
| | | JP 2010177901 A | 12-08-2010 |
| | | KR 20100087653 A | 05-08-2010 |
| | | US 2010189300 A1 | 29-07-2010 |
| US 2012020510 A1 | 26-01-2012 | CN 102308593 A | 04-01-2012 |
| | | EP 2378789 A1 | 19-10-2011 |
| | | JP 2010183312 A | 19-08-2010 |
| | | KR 20110112834 A | 13-10-2011 |
| | | TW 201034476 A | 16-09-2010 |
| | | US 2012020510 A1 | 26-01-2012 |
| | | WO 2010090070 A1 | 12-08-2010 |
| US 2011195745 A1 | 11-08-2011 | CN 102113344 A | 29-06-2011 |
| | | EP 2323421 A1 | 18-05-2011 |
| | | JP 5200737 B2 | 05-06-2013 |
| | | JP 2010034991 A | 12-02-2010 |
| | | TW 201026087 A | 01-07-2010 |
| | | US 2011195745 A1 | 11-08-2011 |
| | | WO 2010013603 A1 | 04-02-2010 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013027451 A

- JP H7307990 B